# EUROPEAN PATENT SPECIFICATION

(11) **EP 3 825 702 B1**
(45) Date of publication and mention of the grant of the patent: **01.11.2023**
(21) Application number: 20206390.5
(22) Date of filing: 09.11.2020
(51) Int. Cl.: G01R 19/30

(54) **SYSTEMS AND METHODS FOR DERIVING INFORMATION FROM SAMPLED DATA ON A HIGH SPEED DATA ACQUISITION DEVICE**
SYSTEME UND VERFAHREN ZUR GEWINNUNG VON INFORMATIONEN AUS ABGETASTETEN DATEN AUF EINER HOCHGESCHWINDIGKEITSDATENERFASSUNGSVORRICHTUNG
SYSTÈMES ET PROCÉDÉS PERMETTANT DE DÉRIVER DES INFORMATIONS À PARTIR DE DONNÉES ÉCHANTILLONNÉES SUR UN DISPOSITIF D'ACQUISITION DE DONNÉES À GRANDE VITESSE

(30) Priority: 19.11.2019 US 201962937411 P; 19.12.2019 US 201916721100
(43) Date of publication of application: 26.05.2021
(73) Proprietor: Schneider Electric USA, Inc., Andover, MA 01810 (US)
(72) Inventor: McPhalen, Erin C., Victoria, British Columbia V8X 4G8 (CA)
(74) Representative: Manitz Finsterwald Patent- und Rechtsanwaltspartnerschaft mbB

(56) References cited:
- CN-A- 109 633 253
- DE-A1- 3 611 657
- DE-A1- 3 612 234
- US-B1- 6 486 652
- US-B1- 6 917 203
- Mathematica Stack Exchange: "Mathematica Stack Exchange", , 27 September 2015 (2015-09-27), XP055791154, Retrieved from the Internet: URL:https://mathematica.stackexchange.com/ questions/23828/finding-local-minima-maxim a-in-noisy-data
- MENGQI LU ET AL: "A Hybrid Event Detection Approach for Non-Intrusive Load Monitoring", ARXIV.ORG, CORNELL UNIVERSITY LIBRARY, 201 OLIN LIBRARY CORNELL UNIVERSITY ITHACA, NY 14853, 21 March 2019 (2019-03-21), XP081156507,

## Description

### CROSS REFERENCE TO RELATED APPLICATION

This application claims the benefit of and priority to U.S. Provisional Application No. 62/937,411, filed on November 19, 2019 under 35 U.S.C. §119(e), which application is incorporated by reference herein in its entirety.

### FIELD

This disclosure relates generally to high-speed data acquisition devices and, more particularly, to systems and methods for deriving information from sampled data, for example, on a high-speed data acquisition device.

### BACKGROUND

As is known, high-speed data acquisition devices are used in a variety of applications. One example application is power quality monitoring applications in which power quality meters monitor an electrical/power system for power quality issues. The power quality meters may include one or more high-speed data acquisition devices, for example, for capturing energy-related signals (e.g., voltage and/or current signals) and identifying transient events in the power system that may be indicative of power quality issues. Mathematica Stack Exchange. "Mathematica Stack Exchange", 27 September 2015, XP055791154, https://mathematica.stackexchange.com/questions/23828/finding-local-minima-maxima-in-noisy-data discloses how to find local minima/maxima in noisy data. US 6 917 203 B1 discloses a current signature sensor. CN 109 633 263 A discloses a circuit and method for achieving voltage transient signal detection based on FPGA. US 6 486 652 B1 discloses a high function, user configurable electricity meter. DE 36 12 234 A1 discloses a method and arrangement for data acquisition and data reduction in disturbance value detection systems.

As is known, in high-speed data acquisition devices and systems, it is typically very processor, bus and memory bandwidth intensive to post process all received data, for example, to characterize identified transient events. This can impact performance of systems and devices (e.g., power quality meters) associated with the power system and the ability of these systems and devices to characterize the identified transient events, and power quality issues associated with the identified transient events, in real (or semi-real) time. As is known, power quality issues are one of the most significant and costly impacts on power systems. Poor power quality is estimated to cost the European economy up to €150 billion annually, for example, according to the Leonardo Power Quality Initiative.¹ Additionally, the U.S. economy experiences losses ranging from $119 billion to $188 billion annually, according to research by the Electric Power Research Institute (EPRI).² Therefore, it is desirable to identify and characterize transient events and power quality issues associated with the transient events as quickly as possible so the power quality issues can be addressed and losses from the power quality issues can be minimized.
¹ https://adfpowertuning.com/en/about-us/news-stories/148-leonardo-energy-qpan-european-power-quality-surveyq-shows-g150bn-annually-in-cost-for-low-power-quality.html
² https://blog.schneider-electric.com/power-management-metering-monitoring-power-quality/2015/10/16/why-poor-power-quality-costs-billions-annually-and-what-can-be-done-about-it/

### SUMMARY

Described herein are systems and methods related to deriving information from sampled data, for example, on a high-speed data acquisition device. The high-speed data acquisition device (e.g., capable of capturing signals in the MHz range) may be utilized in an electrical/power system, for example. The power system may be associated with at least one load, process, building, facility, watercraft, aircraft, or other type of structure, for example.

The invention is defined by a method of deriving information from sampled data in a digital data stream according to claim 1 and the associated device according to claim 21. Further aspects are defined by the corresponding dependent claims.

In accordance with embodiments of this disclosure, by deriving what is considered useful information on a device such as a Field Programmable Gate Array (FPGA), the amount of data to characterize a transient event can be substantially reduced before being passed to a processor or other upstream device. The invention solves this problem by the real time conversion of the data stream to its first derivative representation and determining zero crossings of the data as it is received and deriving the information required to properly characterize a transient waveform.

In some embodiments, the derived information (e.g., from the local minima and maxima and the relative offset) may include at least one of frequency, amplitude and oscillatory attack/decay information. Additionally, in some embodiments, the magnitude of the transient event detected by the high-speed data acquisition device may be characterized on the high-speed data acquisition device and/or on an upstream device (e.g., a computing device or system) by correlating the local minima and maxima and the relative offset associated with the transient event to the incoming data stream.

In some embodiments, the above method may be implemented using a processor of the high-speed data acquisition device. As used herein, the term "processor" is used to describe an electronic circuit that performs a function, an operation, or a sequence of operations. The function, operation, or sequence of operations can be hard coded into the electronic circuit or soft coded by way of instructions held in a memory device. A processor can perform the function, operation, or sequence of operations using digital values or using analog signals.

In some embodiments, the processor can be embodied, for example, in a specially programmed microprocessor, a digital signal processor (DSP), or an application specific integrated circuit (ASIC), which can be an analog ASIC or a digital ASIC. Additionally, in some embodiments the processor can be embodied in configurable hardware such as FPGAs or programmable logic arrays (PLAs). In some embodiments, the processor can also be embodied in a microprocessor with associated program memory. Furthermore, in some embodiments the processor can be embodied in a discrete electronic circuit, which can be an analog circuit, a digital circuit or a combination of an analog circuit and a digital circuit. The processor may be coupled to one or more memory devices, with the processor and the memory device(s) configured to implement the above-discussed method.

In accordance with some embodiments of this disclosure, the high-speed data acquisition device corresponds to a high-speed data acquisition device for use in a metering device. The metering device may be a metering device (e.g., a high-speed transient data acquisition device) for use in a power system, for example.

In some embodiments, the metering device may correspond to an intelligent electronic device (IED). As used herein, an lED is a computational electronic device optimized to perform a particular function or set of functions. Examples of IEDs include smart utility meters, power quality meters, microprocessor relays, digital fault recorders, and other metering devices. IEDs may also be embedded in variable speed drives (VSDs), uninterruptible power supplies (UPSs), circuit breakers, relays, transformers, or any other electrical apparatus. IEDs may be used to perform monitoring and control functions in a wide variety of installations. The installations may include utility systems, industrial facilities, warehouses, office buildings or other commercial complexes, campus facilities, computing co-location centers, data centers, power distribution networks, or any other structure, process or load that uses electrical energy. For example, where the lED is an electrical power monitoring device, it may be coupled to (or be installed in) an electrical power transmission or distribution system and configured to sense/measure and store data as electrical parameters representing operating characteristics (e.g., voltage, current, waveform distortion, power, etc.) of the electrical distribution system. These parameters and characteristics may be analyzed by a user to evaluate potential performance, reliability or power quality-related issues. The lED may include at least a controller (which in certain lEDs can be configured to run one or more applications simultaneously, serially, or both), firmware, a memory, a communications interface, and connectors that connect the lED to external systems, devices, and/or components at any voltage level, configuration, and/or type (e.g., AC, DC). At least certain aspects of the monitoring and control functionality of an lED may be embodied in a computer program that is accessible by the lED.

In some embodiments, the metering devices (e.g., lEDs) and equipment/loads of the above and below described systems and methods are installed, located or derived from different respective locations (i.e., a plurality of locations) or metering points in a power system. A particular lED (e.g., a second IED) may be upstream from another lED (e.g., a third IED) in the power system while being downstream from a further lED (e.g., a first IED) in the power system, for example.

As used herein, the terms "upstream" and "downstream" are used to refer to electrical locations within a power system. More particularly, in one embodiment the electrical locations "upstream" and "downstream" are relative to an electrical location of an lED collecting data and providing this information. For example, in a power system including a plurality of lEDs, one or more lEDs may be positioned (or installed) at an electrical location that is upstream relative to one or more other lEDs in the power system, and the one or more lEDs may be positioned (or installed) at an electrical location that is downstream relative to one or more further lEDs in the power system. A first lED or load that is positioned on an electrical circuit upstream from a second lED or load may, for example, be positioned electrically closer to an input or source of the power system (e.g., a utility feed) than the second lED or load. Conversely, a first lED or load that is positioned on an electrical circuit downstream from a second lED or load may be positioned electrically closer to an end or terminus of the power system than the other lED.

A first lED or load that is electrically connected in parallel (e.g., on an electrical circuit) with a second lED or load may be considered to be "electrically" upstream from said second lED or load in embodiments, and vice versa. In embodiments, algorithm(s) used for determining a direction of a power quality event (i.e., upstream or downstream) is/are located (or stored) in the IED, cloud, on-site software, gateway, etc. As one example, the lED can record an electrical event's voltage and current phase information (e.g., by sampling the respective signals) and communicatively transmit this information to a cloud-based system. The cloud-based system may then analyze the voltage and current phase information (e.g., instantaneous, root-mean-square (rms), waveforms and/or other electrical characteristic) to determine if the source of the power quality event was electrically upstream or downstream from where the lED is electrically coupled to the power system.

With respect to the present invention, it is understood that the high-speed data acquisition device (e.g., of a metering device or IED) responsible for processing incoming data streams to detect transient events may be upstream or downstream from the point(s) in the power system at which the transient events (and power quality issues/events) are occurring. It is also understood that the high-speed data acquisition device may provide the information from, or derived from, the local minima and maxima and the relative offset to other high-speed data acquisition devices (e.g., another lED or metering device) for further processing. The other lED or metering device may correspond to a "higher end" or more computationally intensive lED or metering device (e.g., with more processing power) in some embodiments.

In accordance with some embodiments of this disclosure, the high-speed data acquisition device corresponds to a high-speed data acquisition device for use in a metering device. The metering device may be a metering device (e.g., a high-speed transient data acquisition device) for use in a power system, for example.

Some example systems and devices for which the invention may be found suitable are the PowerLogic ION9000T and PowerLogic CM4000T power quality meters by Schneider Electric, for example.

It is understood that the disclosed systems, methods for deriving information from sampled data, for example, in a digital data stream, may additionally or alternatively be used in other applications besides metering applications. In particular, the concepts and techniques disclosed herein may be found suitable for use in substantially any application where it is desired to derive information from sampled data (and compress and/or reduce the amount of information that is transmitted to upstream devices, and/or be used by a device). For example, the invention could potentially be used to detect/characterize inrush currents and faults resulting from inrush currents. Additionally, the invention could potentially be used to address the issue of transient ground faults. For example, as is known, compensated electrical networks typically face the issue of transient ground faults, for example, in Northern and Central Europe. Due to the frequency behavior of those faults the detection of those faults requires either a specific analog filtering or some high-speed acquisition followed by digital filtering. This invention may provide a solution for replacing the old analog solution with a digital one. In general, the invention is based on computational processing of sampled data in some form, be it a query to a sensor, etc. With this in mind, various systems, methods and devices of deriving information from sampled data are provided herein.

It is understood that many applications of the systems, methods and devices disclosed herein are possible, as will become further apparent from discussions below. It is also understood that there are many advantages associated with the disclosed systems, methods and devices, as will be appreciated from the discussions below.

### BRIEF DESCRIPTION OF THE DRAWINGS

The foregoing features of the disclosure, as well as the disclosure itself may be more fully understood from the following detailed description of the drawings, in which:
FIG. 1 is a block diagram of an example power system including a signal source and a metering device, the metering device including a high-speed data acquisition device;
FIG. 2 shows an example implementation of a high-speed data acquisition device in accordance with embodiments of this disclosure;
FIG. 3 is a flowchart illustrating an example method for deriving information from sampled data, for example, on a high-speed data acquisition device, in accordance with embodiments of the disclosure;
FIG. 3A is a flowchart illustrating an example method for detecting transient events, for example, using the data collected using the method shown in FIG. 3;
FIG. 4 shows an example process for converting/transform a digital data stream to its first derivative representation and using zero crossing information from the first derivative representation to determine local minima and maxima and their relative offset in time;
FIGS. 5, 5A and 5B show an example process for determining relative offset of local minima and maxima; and
FIGS. 6 and 6A show example tables from Institute of Electrical and Electronics Engineer (IEEE) Standard 1159-2019, known art.

### DETAILED DESCRIPTION

The features and other details of the concepts, systems, and techniques sought to be protected herein will now be more particularly described. It will be understood that any specific embodiments described herein are shown by way of illustration and not as limitations of the disclosure and the concepts described herein. Features of the subject matter described herein can be employed in various embodiments without departing from the scope of the concepts sought to be protected.

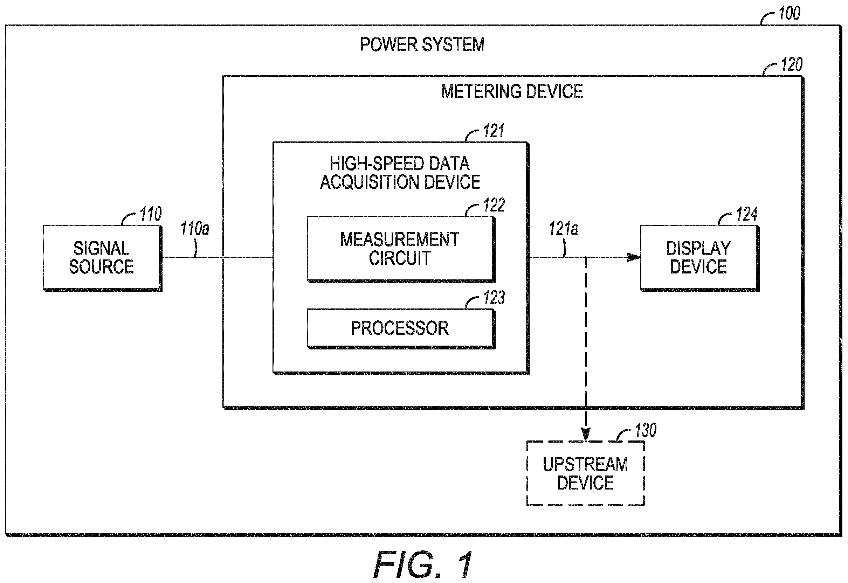

Referring to FIG. 1, an example power system 100 in accordance with embodiments of this disclosure includes a signal source 110 and a metering device 120 capable of monitoring one or more parameters of the signal source 110. The signal source 110 and the metering device 120 may each take a variety of forms. For example, the signal source 110 may take the form of a renewable energy source (e.g., hydropower, geothermal, wind, and solar) or a non-renewable energy source (e.g., fossil fuel power plant). Additionally, the metering device 120 may take the form of a device (e.g., an intelligent electronic device (IED)) for monitoring the amount of electric energy consumed by a residence or business, or a particular electrically powered device of the residence or business. The metering device 120 may be coupled to the signal source 110 by one or more connectors and/or mediums (e.g., transmission lines or other wired or wireless mediums).

In some embodiments, the signal source 110 may be provided as, include, or be coupled to one or more loads in the power system 100. The loads may include, for example, machinery or apparatuses associated with a particular application (e.g., an industrial application), applications, and/or process(es). The machinery may include electrical or electronic equipment, for example. The machinery may also include the controls and/or ancillary equipment associated with the electrical or electronic equipment.

In the example embodiment shown, the metering device 120 includes a high-speed data acquisition device 121 and a display device 124. The high-speed data acquisition device 121 is coupled to receive a signal (or signals) 110a generated by the signal source 110 at an input and configured to generate a signal (or signals) 121a indicative of one or more monitored parameters of the signal 110a at an output thereof. For example, the high-speed data acquisition device 121 may be configured to capture/sample energy-related signals (e.g., voltage and/or current signals) from the signal(s) 110a, for example, using a measurement circuit 122. A signal (or signals) indicative of the captured energy-related signals may be generated at an output of the measurement circuit 122 and processed by a processor 123 (e.g., an FPGA) of the high-speed data acquisition device 121 to detect a transient event (e.g., a voltage and/or current transient event). In some embodiments, the signal (or signals) generated at the output of the measurement circuit 122 take the form of a digital data stream, and the processor 123 processes the digital data stream (i.e., an incoming data stream) to detect the transient event in data stream. In some embodiments, the signal(s) 121a generated at the output of the high-speed data acquisition device 121 is indicative of the detected transient events.

In some embodiments, the output signal 121a may be provided to a display device for displaying the monitored parameters (or select ones of the monitored parameters), or information associated with the monitored parameters (such as transient events). The display device may be the display device 124 of the metering device 120, as shown. Additionally, or alternatively, the display device may be a display device of a remote computing device, for example.

In some embodiments, the output signal 121a may also be provided to one or more upstream devices 130, for example, for further processing. For example, in embodiments in which the output signal 121a is indicative of a transient event, the output signal 121a may be provided to the upstream device(s) 130 to characterize the transient event. The characterization of the transient event (as further discussed in connection with figures below) may be used, for example, to identify power quality issues (e.g., voltage sags, voltage swells, and voltage transients) in the power system 100. It is understood there are types of power quality issues and there are certain characteristics of these types of power quality issues/events, for example, as defined in IEEE Standard 1159-2019 (known art). In accordance with embodiments of the disclosure, information from, or derived from, the output signal 121a may be correlated or compared with defined characteristics (e.g., standard or user defined characteristics, such as duration and magnitude) of power quality issues/events to detect the power quality issues.

In some embodiments, the upstream devices 130 may include, correspond to, or be coupled to control systems or devices (e.g., in or associated with the power system 100). The control systems or devices may, for example, configure (or control or adjust) one or more of the monitored parameters (or loads in the power system 100), and/or take one or more actions in response to the output signal 121a. For example, in embodiments in which the output signal 121a is indicative of power quality issues identified from detected transient events, the output signal 121a may be used by the metering device 120 and/or control circuitry to identify event mitigation opportunities or reduce (or ideally eliminate) an impact of a power quality issue/event and install a mitigation device and/or perform mitigative actions, for example, as described in co-pending U.S. Patent Application No. 16/137,603, entitled "Dynamic Tolerance Curves For Power Monitoring Systems", which is assigned to the same assignee as the present disclosure. It is understood that other actions (e.g., generation of alarms, such as transient alarms, etc.) may be additionally or alternatively be taken.

While the output signal 121a is described being provided to the upstream device(s) 130 for further processing in some embodiments, it is understood that in some embodiments the output signal 121a need not be sent to the upstream device(s) 130. For example, in some embodiments substantially all processing may occur on the metering device 120, for example, on the high-speed data acquisition device processor 123. For example, in some embodiments the high-speed data acquisition device processor 123 may be configured to at least detect and characterize transient events, as will be appreciated from further discussions below.

In some embodiments, at least some of the processing may additionally or alternatively occur remote from the metering device 120, for example, in a cloud computing system. As used herein, the terms "cloud" and "cloud computing" are intended to refer to computing resources connected to the Internet or otherwise accessible to the metering device 120 via a communication network, which may be a wired or wireless network, or a combination of both. The computing resources comprising the cloud may be centralized in a single location, distributed throughout multiple locations, or a combination of both. A cloud computing system may divide computing tasks amongst multiple racks, blades, processors, cores, controllers, nodes or other computational units in accordance with a particular cloud system architecture or programming. Similarly, a cloud computing system may store instructions and computational information in a centralized memory or storage, or may distribute such information amongst multiple storage or memory components. The cloud system may store multiple copies of instructions and computational information in redundant storage units, such as a RAID array.

As noted in the Background section of this disclosure, in high-speed data acquisition devices and systems, it is typically very processor, bus and memory bandwidth intensive to post process all received data (e.g., from signals 110a). For example, the data captured and output by the high-speed data acquisition devices can be very substantial, particularly in applications in which the data/signals received at inputs of the high-speed data acquisition devices are quite large. This can impact performance of the high-speed data acquisition devices and systems and devices (e.g., upstream devices 130) coupled to receive data/signals from the high-speed data acquisition devices. For example, in embodiments in which the high-speed data acquisition devices are configured to detect and characterize transient events, the data used by the high-speed data acquisition devices to characterize the transient events can be quite large, which can impact the time it takes the high-speed data acquisition devices to characterize the transient events. Additionally, this can increase the processing and storage requirements of the high-speed data acquisition devices, which can impact the costs of the high-speed data acquisition devices.

Similarly, in embodiments in which the high-speed data acquisition devices are configured to detect transient events and provide information to other systems and devices (e.g., upstream or cloud-computing devices) for characterizing the transient events, the provided information can be quite large, which can impact the time it takes the other systems and devices to characterize the transient events. This can also increase the processing and storage requirements of the other systems and devices, which can impact the costs of these systems and devices. As is known, cloud-computing costs, for example, can get quite expensive and potentially be cost prohibitive.

For at least the above reasons, and other reasons as will be apparent to one of ordinary skill in the art, it is desirable to reduce the amount of information that is generated and used to characterize a transient event (and other types of events) in a power system (e.g., 100, shown in FIG. 1). In accordance with embodiments of this disclosure, information may be derived from a digital data stream and this information (i.e., a reduced set of information) may be used to characterize a transient event (and other types of events) in the power system. Example systems and methods for deriving information from a digital data stream (and other forms of sampled data) are discussed in connection with figures below.

It is understood that the power system shown in FIG. 1 (i.e., power system 100) is but one of many potential configurations of power systems in accordance with embodiments of this disclosure. For example, while the power system 100 is shown as including a single signal source 110 and a single metering device 120 in the illustrated embodiment, it is understood that the power system 100 may include a plurality of signal sources and/or a plurality of metering devices in some embodiments. In embodiments in which the signal source(s) is/are provided as, includes, or is/are coupled to one or more loads in the power system 100, the metering device(s) may be coupled to a respective one or more of the loads. In addition to capturing/detecting transient events, the metering device(s) may be configured to monitor, analyze and/or control one or more parameters (e.g., energy-related parameters) associated with the loads, for example. It is understood that other configurations of power systems are possible.

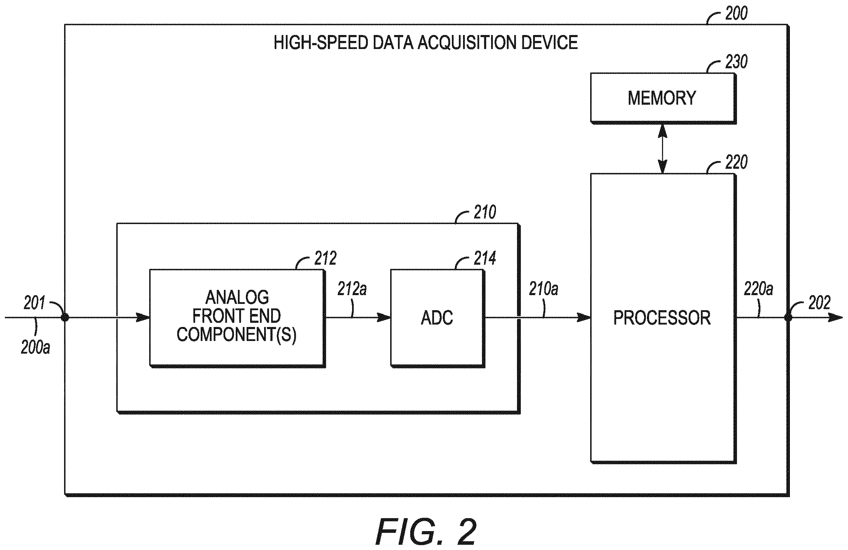

Referring to FIG. 2, an example high-speed data acquisition device 200 that may be used to derive information from a digital data stream in accordance with embodiments of this disclosure is shown. In accordance with some embodiments of this disclosure, the high-speed data acquisition device 200 may be used in a metering device (e.g., 120, shown in FIG. 1) or another suitable device.

In the illustrated embodiment, the high-speed data acquisition device 200 has at least one input (here, an input 201) and at least one output (here, an output 202). Additionally, in the illustrated embodiment the high-speed data acquisition device 200 includes a signal path 210 (e.g., analog, digital and/or mixed signal path), a processor 220 and a memory device 230. The signal path 210, which may correspond to a measurement circuit of the device 200, for example, includes one or more analog front end components 212 and an analog-to-digital converter (ADC) 214, with the analog front end components 212 having a first terminal coupled to high-speed data acquisition device input 201 and a second terminal coupled to a first terminal of the ADC 214. Additionally, the ADC 214 has a second terminal coupled to a first terminal of the processor 220, and the processor 220 has a second terminal coupled to measurement circuit output 202. The memory device 230 is coupled to a third terminal of the processor 220. In some embodiments, the high-speed data acquisition device input 201 is coupled to an input of a metering device (e.g., 120, shown in FIG. 1) or other device in which the high-speed data acquisition device 200 may be used. Additionally, in some embodiments, the high-speed data acquisition device output 202 is coupled to an output of the metering device and/or other components (e.g., display device 124, shown in FIG. 1) of the metering device or other device. As discussed above in connection with FIG. 1 with reference to metering devices, the metering device may be coupled to one or more signal sources (e.g., 110, shown in FIG. 1) and one or more upstream devices (e.g., 130, shown in FIG. 1).

In accordance with one embodiment of this disclosure, the analog front end components 212 of signal path 210 include at least one component for measuring/sampling parameters (e.g., voltage, current, etc.) of an input signal (here, input signal 200a). In embodiments, the at least one component may take the form a resistor (e.g., a current sense resistor), a capacitor, and/or substantially any other type of element (or elements) or sensor which may be found suitable for measuring the parameters. It is understood that the quantity of the at least one component (e.g., one element, two elements, three elements, etc.) and arrangement(s) of the at least one component (e.g., serial or parallel coupling) may be selected based, at least in part, on the parameter(s) to be measured by the at least one component. For example, in embodiments in which the at least one component is configured to measure a voltage level of the input signal 200a, for example, to detect a transient event, the at least one component may include a plurality of measurement elements. The plurality of measurement elements may be coupled in a divider configuration, for example. It is understood that the analog front end components 212 may additionally or alternatively include one or more other analog components, for example, capacitors, inductors, diodes, transistors, and operational amplifiers. The analog front end components 212 may take the form of active electrical components and/or passive electrical components.

The processor 220, which may take the form of an FPGA or another type of processor suitable for the application(s) in which the high-speed data acquisition device 200 is used, is coupled to the signal path 210 (here, to an output of ADC 214 in signal path 210) and to a memory device 230. The memory device 230 may include volatile memory, such as DRAM or SRAM, for example. The memory device 230 may store programs and data collected (e.g., sampled/measured parameters) during operation of the high-speed data acquisition device 200, for example. The memory device 230 may also include a computer readable and writeable nonvolatile recording medium, such as a disk or flash memory, in which signals are stored that define a program to be executed by the processor 220 or information to be processed by the program. The processor 220 may control transfer of data between the memory device 210 and the processor 220 (e.g., for processing by the processor 220) in accordance with known computing and data transfer mechanisms.

During operation of high-speed data acquisition device 200, the device 200 is configured to receive an input signal 200a at input 201 and to provide an output signal 220a indicative of the input signal 201a at output 202. In accordance with some embodiments, the output signal 220a is indicative of a level or value of one or more parameters (e.g., voltage, current, etc.) associated with the input signal 200a. More particularly, in some embodiments the analog front end components 212 are coupled to the input signal 200a and configured to provide an analog signal 212a (i.e., an initial measurement signal) indicative of a respective one or more of the parameters. In some embodiments, the analog signal 212a is related to a value (e.g., a measured resistance value, or charge) of the analog front end components 212. Additionally, in some embodiments the analog signal 212a is related to an output of the analog front end components 212, or to an output of a node proximate to the analog front end components 212.

The ADC 214 is responsive to the analog signal 212a (e.g., an analog input signal to the ADC) to provide a corresponding converted digital signal 210a at an output of the signal path 210. The digital signal 210a may take the form a digital data stream representative of the analog signal 212a in some embodiments. The digital signal 212a is hereinafter referred to as a digital data stream 212a for simplicity.

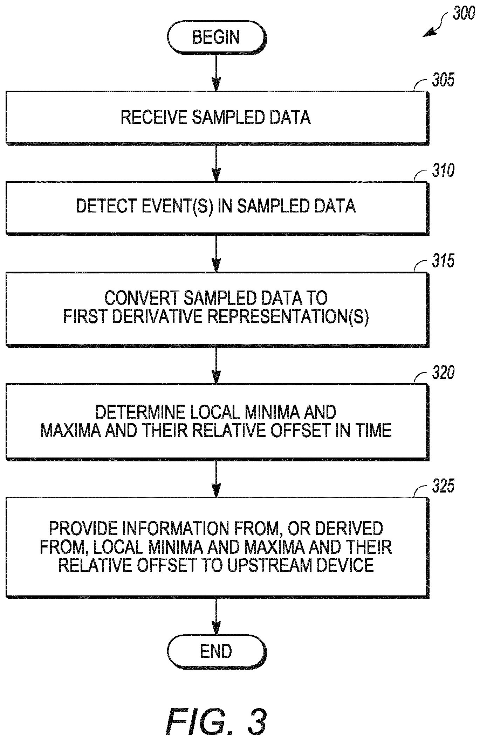

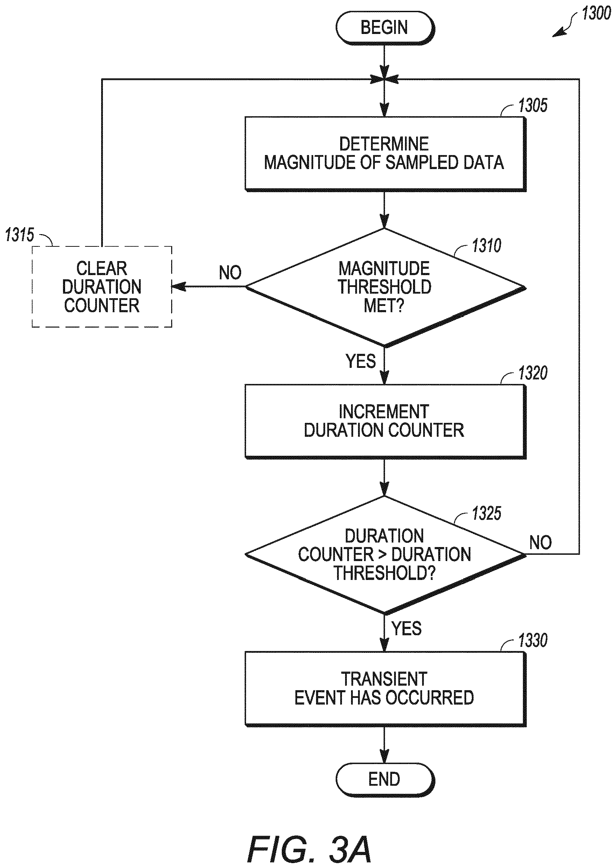

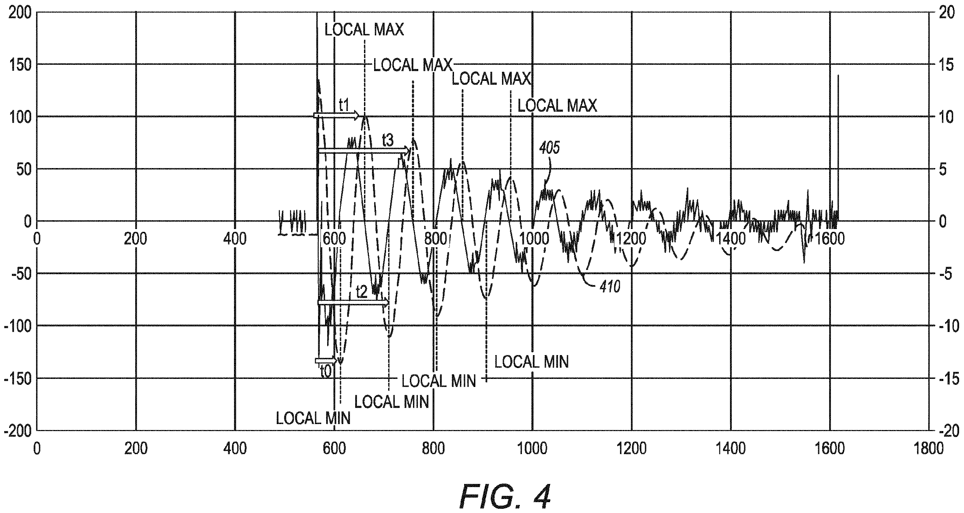

The processor 220 is responsive to the digital data stream 220a, for example, to detect a transient event in the data stream 220a in accordance with embodiments of this disclosure. Additionally, the processor 220 is configured to convert the digital data stream 220a to its first derivative representation to determine local minima and maxima based on zero crossings, as will be discussed further below in connection with FIGS. 3 and 4, for example. In some embodiments, information from, or derived from, the local minima and maxima and a relative offset associated with the transient event may be provided at an output of the processor 220, for example, in the form of an output signal 220a. The output signal 220a may be provided to output 202 of high-speed data acquisition device 200 and, in some embodiments, be received by an upstream device (e.g., 130, shown in FIG. 1) for further processing. For example, in some embodiments the output signal 220a (or a signal representative of the output signal 220a) may be processed by the upstream device to characterize the transient event detected by the processor 220. In other embodiments, the transient event may be characterized on the high-speed data acquisition device (e.g., on processor 220) using the information from, or derived from, the local minima and maxima and the relative offset associated with the transient event.

In accordance with embodiments of this disclosure, by providing only information from, or derived from, the local minima and maxima and the relative offset to the upstream device (i.e., rather than transmitting the entire signal received from the signal source), this can increase performance of the high-speed data acquisition device and/or other systems or device associated with the high-speed data acquisition device (e.g., upstream device(s)). Additionally, this can enable faster detection and characterization of transient events and associated power quality issues, to speed up addressing the power quality issues (e.g., by taking one or more actions in a power system) and thereby minimize losses or impacts due to the power quality issues.

It is understood that high-speed data acquisition device 200 is but one of many potential configurations of high-speed data acquisition devices in accordance with embodiments of this disclosure. For example, while the signal path 210 is shown as including analog front end components 212 and an ADC 214, it is understood that different arrangements of the signal path 210 are possible. For example, the signal path 210 may include additional (or alternative) electrical components in some embodiments, such as operational amplifiers, transistor based amplification circuits, demodulation circuits, comparators, latches, other means for converting analog signals to digitals signals (e.g., using a slope comparator), etc. It is understood that in some embodiments the processor 220 can perform the function, operation, or sequence of operations of one or more portions of the signal path 210. It is also understood that in some embodiments the memory device 230 may be provided as part of the processor 220 (e.g., as onboard EEPROM). Other variations are of course possible.

Referring to FIGS. 3 and 3A, flowcharts (or flow diagrams) are shown to illustrate example methods in accordance with embodiments of this disclosure. Rectangular elements (typified by element 305 in FIG. 3), as may be referred to herein as "processing blocks," may represent computer software and/or algorithm instructions or groups of instructions. Diamond shaped elements (typified by element 1310 in FIG. 3A), as may be referred to herein as "decision blocks," represent computer software and/or algorithm instructions, or groups of instructions, which affect the execution of the computer software and/or algorithm instructions represented by the processing blocks. The processing blocks and decision blocks (and other blocks shown) can represent steps performed by functionally equivalent circuits such as a digital signal processor circuit or an application specific integrated circuit (ASIC).

The flowcharts do not depict the syntax of any particular programming language. Rather, the flowcharts illustrate the functional information one of ordinary skill in the art requires to fabricate circuits or to generate computer software to perform the processing required of the particular apparatus. It should be noted that many routine program elements, such as initialization of loops and variables and the use of temporary variables are not shown. It will be appreciated by those of ordinary skill in the art that unless otherwise indicated herein, the particular sequence of blocks described is illustrative only and can be varied. Thus, unless otherwise stated, the blocks described below are unordered; meaning that, when possible, the blocks can be performed in any convenient or desirable order including that sequential blocks can be performed simultaneously and vice versa. It will also be understood that various features from the flowcharts described below may be combined in some embodiments. Thus, unless otherwise stated, some features from the flowcharts described below may be combined with other features of the flowchart described below, for example, to capture the various advantages and aspects of systems and methods associated with deriving information from sampled data sought to be protected by this disclosure. It is also understood that various features from the flowcharts described below may be separated in some embodiments. For example, while the flowcharts are shown having many blocks, in some embodiments the illustrated method shown by these flowcharts may include fewer blocks or steps.

Referring to FIG. 3, a flowchart illustrates an example method 300 for deriving information from sampled data, for example, on a high-speed data acquisition device (e.g., 200, shown in FIG. 2). Method 300 may be implemented, for example, on a processor of or associated with the high-speed data acquisition device (e.g., 220, shown in FIG. 2).

As illustrated in FIG. 3, the method 300 begins at block 305, where data (e.g., 200a) is captured or received by the high-speed data acquisition device. In one embodiment, a signal (or signals) indicative of the data, for example, in the form of a digital data stream, may be received at an input of a processor (e.g., 220, shown in FIG. 2) of the high-speed data acquisition device, for example, from an output of an ADC (e.g., 214, shown in FIG. 2) of the high-speed data acquisition device or another source. The data may be captured/sampled by the high-speed data acquisition device or another system or device associated with the high-speed data acquisition device.

As discussed above in connection with FIG. 2, for example, in some embodiments a signal may be received at an input of the high-speed data acquisition device and a digital data stream indicative of the input signal may be provided at an output of an ADC (or similar device) in the high-speed data acquisition device. The input signal may be indicative of, or correspond to, energy-related signals captured/sampled by the high-speed data acquisition device, for example. The energy-related signals may include, for example, at least one of: a voltage signal, a current signal, and a derived energy-related value. In some embodiments, the derived energy-related value includes at least one of: a calculated, derived, developed, interpolated, extrapolated, evaluated, and otherwise determined additional energy-related value from the at least one of the voltage signal and the current signal. It is understood that many other derived energy-related value(s) and types of energy-related signals (and other input signals) are possible.

In embodiments in which the high-speed data acquisition device is provided in a metering device, for example, the input signal may be associated a particular metering point or points in a power system and/or be associated with a particular signal source and/or load(s) in the power system. The metering device may be installed or located, for example, at a respective metering point of a plurality of metering points in the power system, and coupled to one or more signals sources and/or loads in the power system.

Returning now to method 300, at block 310 the data stream received at block 305 is processed to detect one or more events, for example, transient events, in the power system in which the high-speed data acquisition device is provided. One example method for detecting transient events is described further in connection with FIG. 3A, for example. In accordance with one embodiment of this disclosure, the transient event is just used to determine the common reference point in time. If a transient is not detected, then no data would need to be collected in some embodiments. Alternatively, the data can be collected continuously and an arbitrary reference point for time would be selected. In one embodiment, if a transient event (or another type of event) is not detected, the method returns to block 305.

At block 315, the sampled data, or a signal indicative of the sampled data such as in the form of a digital data stream, is converted/transformed to its first derivative representation. For example, referring also to FIG. 4, in one embodiment the sampled data (e.g., 405, shown in FIG. 4) may be converted to its first derivative representative (e.g., 410, shown in FIG. 4) by determining dy/dt =(yₙ-y₍ₙ₋₁₎)/dt or the forward looking version dy/dt =(y₍ₙ₊₁₎-yₙ)/dt or centered difference dy/dt=(y₍ₙ₊₁₎-y₍ₙ₋₁₎)/2dt or other methods of determining the first derivative. In a sampled system dt can simply be taken to be one. All are numerically equivalent. In accordance with some embodiments of this disclosure, the conversion/transformation of the data stream to its first derivative representation occurs during the transient event (i.e., in real or semi-real time). In accordance with other embodiments of this disclosure, the conversion/transformation of the sampled data to its first derivative representation may occur at substantially any time. For example, the conversion/transformation may occur from the time when the meter (or other device) powers up as time equals zero, then all local minima/maxima could be captured based on the first derivative representation, for example, at block 320.

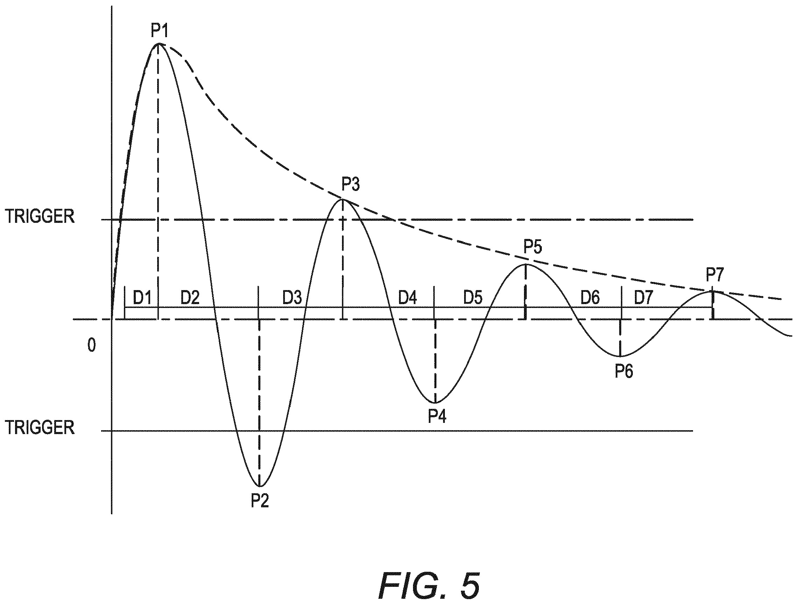

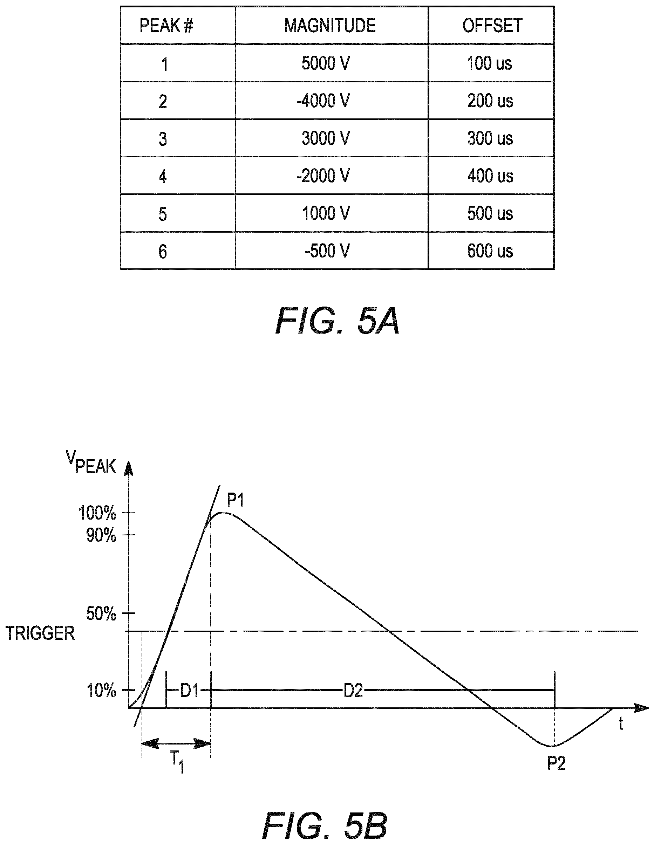

At block 320, zero crossing information from the first derivative representation of the sampled data is used to determine local minima and maxima, for example, as shown in FIG. 4. The zero crossing information may be indicative of local minima or maxima occurring, for example, based on a direction (i.e., change of sign) of zero crossings indicated in the zero crossing information. In embodiments, the zero crossing information may be used to determine the local minima and maxima's relative offset in time to a common point in time, for example, as indicated in FIG. 4 by T1, T2, T3. For example, some event occurs and this would be taken to be t=0 for all channels. The reporting would include the magnitude and how long from t=0 time that local min or max occurred. Referring also briefly to FIGS. 5, 5A and 5B, various local minima (P2, P4, P6) and local maxima (P1, P3, P5, P7) are shown in another example. The times in the figures show the offset relative to the last peak (which is the same in principle as their being an offset to a fixed point in time). We can say that D2 is the taken from the same start point as D1, for example. Alternatively, it is obvious to one skilled in the art that numerically if D2 is taken relative to the peak of D1, then D1+D2 will provide the same relative offset point as D1, and so on. Either method will provide numerically equivalent results.

With reference to FIG. 5, this figure shows a typical oscillatory transient waveform. The described invention will identify the local maxima and minima associated with the waveform as indicated by local maxima P1, P3, P5, P7 and their associated offset indicated D1, D3, D5, D7 and the local minima P2, P4, P6 and there associated offset D2, D4, D6. FIG. 5A shows select data from an analysis performed on the waveform shown in FIG. 5. In FIG. 5B, a typical impulsive transient waveform is also shown. The described invention will identify the local maxima P1 and its associated offset D1 and the local minima P2 and its associated offset D2. In general, the above-discussed figures show typical transient waveforms, other forms of transients containing local minima and/or maxima and their associated duration that may be characterized by the invention disclosed herein.

Returning now to FIG. 3, at block 325, information from, or derived from, the local minima and maxima and the relative offset associated with the transient event (and/or other type(s) of event(s)), may be transmitted to an upstream device for further processing. For example, with reference to transient event, the magnitude of a transient event may be characterized and the resulting metadata may be transmitted to the upstream device for further processing. The metadata may include, for example, the magnitude and time offset of each local maxima or minima and/or information related to the magnitude and time offset of each local maxima or minima.

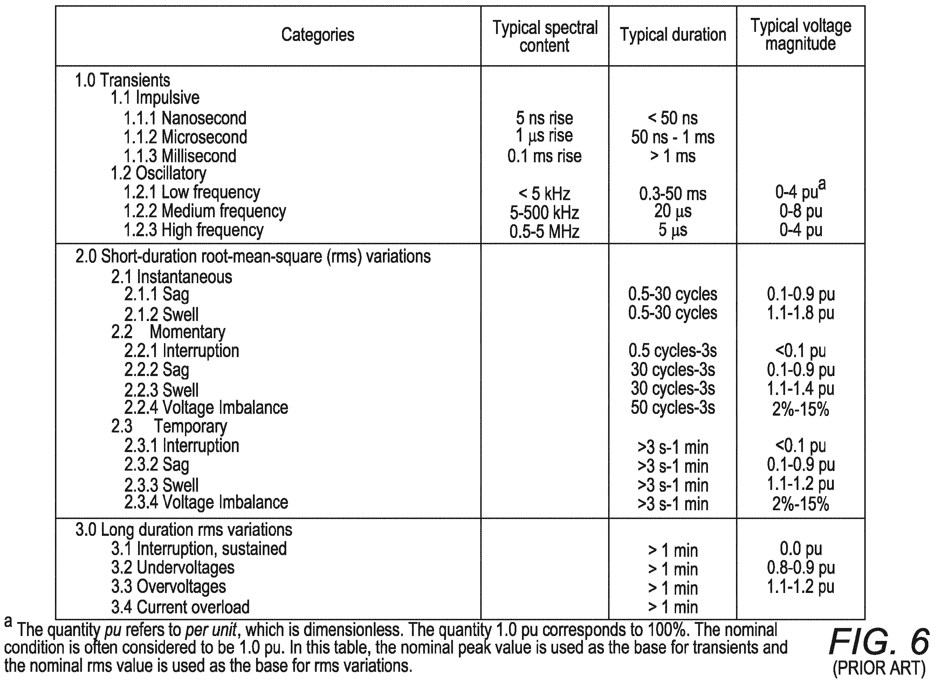

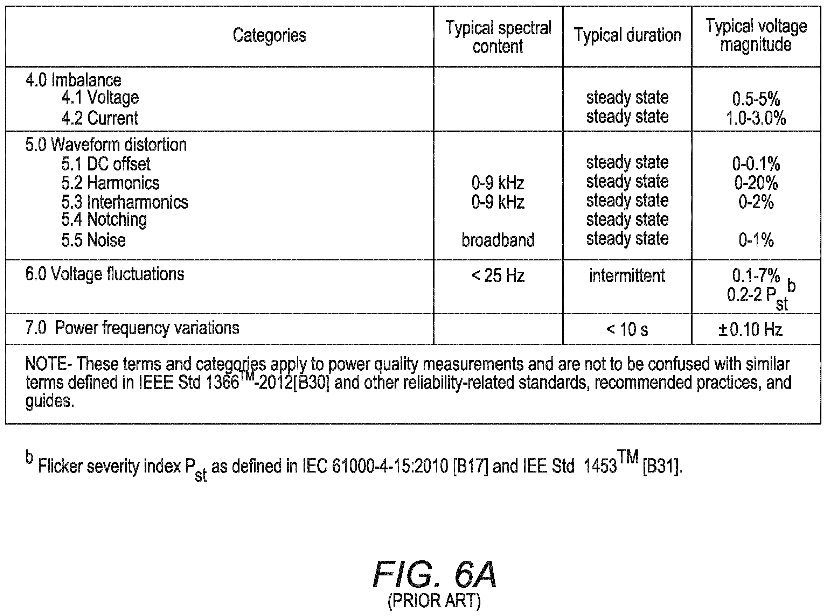

In one embodiment, the magnitude of the transient event may be characterized by correlating the local minima and maxima and the relative offset associated with the transient event to the incoming sampled data (i.e., the data captured/received at block 305). Additionally, in one embodiment the metadata may be processed by the upstream device to further characterize the transient event. For example, the magnitude and duration of the transient event (as contained in the metadata) may be correlated or compared with user and/or standard defined characteristics of transient events (e.g., as defined in IEEE Standard 1159-2019, for example, as shown in FIGS. 6 and 6A) to characterize the transient event. A high frequency oscillatory transient, for example, is defined as having a typical voltage magnitude of about zero to four per-unit (pu) and a duration of about five microseconds (µs) in IEEE Standard 1159-2019, for example, which defines various categories and characteristics of power system electromagnetic phenomena. In embodiments in which the magnitude and duration of data in the data stream matches the characteristics of a high frequency oscillatory transient, for example, it may be determined that a high frequency oscillatory transient has occurred. It is understood that this is but one of many potential transients (and other types of events) that may be detected, captured and characterized by the high-speed data acquisition device and/or the upstream device.

Subsequent to block 325, the method may end in some embodiments. In other embodiments, the method may return to block 305 and repeat again (e.g., to capture transient events and/or other events in newly received input signals/data streams). In some embodiments in which the method ends after block 325, the method may be initiated again in response to user input and/or a control signal, for example.

It is understood that method 300 may include one or more additional or alternative blocks in some embodiments. For example, in some embodiments the method may further include using information about the transient event to detect power quality issues (e.g., voltage sags, swells, etc.) in the power system, and taking one or more actions based on the detected power quality events. For example, the information about the transient event and power quality issues may be used to identify event mitigation opportunities to reduce (or ideally eliminate) an impact of the power quality issues/events, install a mitigation device and/or perform mitigative actions. As one example, a surge device may be installed or activated to reduce (or ideally eliminate) an impact of the power quality issues/events. With respect to surge devices, as is known these devices are used to mitigate voltage transients by 1) providing a low impedance path for current to flow during a voltage transient event, and 2) absorbing and diverting extraneous currents associated with a voltage transient to ground in order to protect loads/equipment from the effects of a voltage transient (e.g., surge).

In some embodiments, instead of the information from, or derived from, the local minima and maxima and the relative offset associated with the transient event (and/or other type(s) of event(s)), being transmitted to an upstream device for further processing, the information may be processed on the high-speed data acquisition device. For example, similar to the embodiment discussed above, the information may be processed by the high-speed data acquisition device (e.g., using a processor of the device) to, at least in part, characterize the transient event (and/or other type(s) of event(s)).

For example, it is understood that high-speed data acquisition devices may take various forms and have an associated complexity (or set of functional capabilities and/or features). For example, an "intermediate" high-speed data acquisition device may have more functionality (e.g., processing features, memory and/or capabilities) than a "basic" high-speed data acquisition device, and an "advanced" high-speed data acquisition device may have more functionality and/or features than the intermediate high-speed data acquisition device. In accordance with some embodiments of this disclosure, it may be desirable to perform at least some of the characterization of the event(s) on the intermediate or advanced devices, for example, prior to or instead of transmitting data to upstream device(s).

It is understood that the above-discussed method significantly compresses or reduces the amount of information that is transmitted to upstream device(s), and/or be used by high-speed data acquisition device(s) to characterize events, etc., for example, by converting the data to its first derivative representative and determining local minima and maxima and their relative offset. As noted above, this may reduce storage requirements and costs associated with characterizing events, etc., and increase speed of event characterization and speed to respond to event(s). Many other advantages and benefits are associated with the systems and methods disclosed herein, as will be appreciated by one of ordinary skill in the art.

Referring to FIG. 3A, an example method 1300 for detecting transient events in accordance with embodiments of this disclosure is shown. The method 1300 may, for example, correspond to example steps performed at block 310 of method 300 to detect transient events in sampled data (e.g., data sampled at block 305 of method 300).

As illustrated in FIG. 3A, the method 1300 begins at block 1305, where sampled data is processed/tracked to determine the magnitude of data in the sampled data. As discussed above in connection with block 305, the sampled data may correspond to, include, or be converted to, a digital data stream (or another form of sampled data). In embodiments, the sampled data may be stored/retrieved from a memory device associated with a high-speed transient device and/or be processed in real (or semi-real) time. In one example implementation, at block 1305, the absolute value of the sampled data is taken to determine its magnitude.

At block 1310, it is determined if the magnitude of the sampled data is greater than or equal to a magnitude threshold (e.g., using a comparator or comparison algorithm in the high-speed data acquisition device). The magnitude threshold may, for example, be indicative of the presence of a transient event (or another event). In one example implementation, the magnitude threshold corresponds to the minimum magnitude required to be determined a transient. In accordance with some embodiments of this disclosure, the magnitude threshold is a user-configured or user-configurable threshold. Additionally, in accordance with some embodiments of this disclosure, the magnitude threshold is automatically determined/set based on one or more standards (e.g., IEEE Standard 1159-2019) which define characteristics (e.g., magnitudes) associated with transient events (or the other types of events being detected). For example, a high frequency oscillatory transient is described as having a typical voltage magnitude of 0-4 pu (per-unit).

At block 1310, if it is determined that the magnitude of the data is greater than or equal to the magnitude threshold (i.e., the magnitude threshold has been met), the method proceeds to block 1320 where a duration counter associated with the potential transient event is incremented, for example, from a first value to a next value greater than the first value, for example, to indicate the number of samples intervals that the magnitude threshold has been exceeded. For example, in a first run through the method 1300, the duration counter (or count values associated with the duration counter) may be incremented from zero to a value greater than zero. Additionally, in second and subsequent runs through method 1300, the duration counter (or count values associated with the duration counter) may be incremented from the value greater than zero to a greater value. It is understood that the duration counter may be implemented in hardware, software, or a combination thereof.

Returning now to block 1310, if it is determined that the magnitude of the data is not greater than or equal to the magnitude threshold (i.e., the magnitude threshold has not been met), the method may proceed to block 1315 or return to block 1305, for example. For example, in embodiments in which the above-discussed duration counter is greater than zero, the duration counter may be cleared at block 1315, and the method may then return to block 1305 for processing of additional sampled data (e.g., a next sample). Additionally, in embodiments in which the duration counter is equal to zero, the method may return to block 1305 after block 1310 for processing of additional sampled data.

At block 1325, subsequent to the data counter being incremented at block 1320, it is determined if the duration counter (i.e., the previously incremented counter at block 1320) is greater than or equal to a duration threshold (e.g., using a comparator or comparison algorithm). The duration threshold, in combination with the magnitude threshold, may, for example, be indicative of the presence of a transient event or the minimum duration of a transient required to be considered of concern for further analysis. In accordance with some embodiments of this disclosure, the duration threshold, similar to the magnitude threshold, is a user-configured or user-configurable threshold. Additionally, in accordance with some embodiments of this disclosure, the duration threshold is automatically determined/set based on one or more standards (e.g., IEEE Standard 1159-2019) which define characteristics (e.g., durations) associated with transient events.

If it is determined that the duration counter is greater than or equal to the duration threshold (i.e., the duration threshold has been met), the method proceeds to block 1330 where it is determined that a transient event (or transient of concern) has occurred and further processing of the data commences (e.g., at block 315 of method 300). Alternatively, if it is determined that the duration counter is not greater than or equal to the duration threshold (i.e., the duration threshold has not been met), the method may proceed to block 1305 where additional sampled data if processed. For example, it may be too premature to detect the presence of a transient event in a first run through the method 1300. However, upon subsequent runs through the method 1300 (with the magnitude threshold met and the duration eventually meeting the duration threshold), it may be determined that a transient event exists. Alternatively, a temporary spike in the data may be indicative of a momentary interruption rather than a transient event.

Subsequent to block 1330, the method may end in some embodiments. In other embodiments, the method may return to block 1305 and repeat again (e.g., to capture transient events in newly received input signals/data streams). In some embodiments in which the method ends after block 1330, the method may be initiated again in response to user input and/or a control signal, for example. It is understood that the method 1300 may include one or more additional or alternative steps in some embodiments.

As illustrated above, the magnitude and duration of sampled data may be analyzed to determine if a transient event has occurred (i.e., detect the presence of the transient event). A duration of zero, for example, would just require the magnitude to be exceeded for instance. For example, in one example implementation, the system or application sets a magnitude threshold (e.g., how large the signal is), and a duration threshold (e.g., how long it exceeded the magnitude threshold for). If the duration is set to zero then the only requirement for a transient to be captured is that the magnitude is exceeded.

While FIG. 3A is discussed primarily with reference to detecting transient events, it is understood that similar methods may be applied to detect other types of events, such as inrush currents, as will be apparent to one of ordinary skill in the art.

As illustrated in this disclosure, the invention proposes systems and methods for deriving information (e.g., advanced analytics information) from sampled data, for example, in a digital data stream. In accordance with embodiments of this disclosure, by deriving what is considered useful information on a device such as an FPGA, the amount of data to characterize a transient event can be substantially reduced before being passed to a processor or other upstream device. The invention solves this problem by the real-time conversion of the data stream to its first derivative representation and determining zero crossings of the data as it is received and deriving the information required to properly characterize a transient waveform.

As described above and as will be appreciated by those of ordinary skill in the art, embodiments of the disclosure herein may be configured as a system, method, or combination thereof. Accordingly, embodiments of the present disclosure may be comprised of various means including hardware, software, firmware or any combination thereof within the scope of the appended claims.

## Claims

1. A method (300) of deriving information from a digital data stream in a high-speed data acquisition device (121), the method comprising:
processing an incoming high-speed data stream in the high-speed data acquisition device (121) to detect (310) a transient event in a power system (100) from the data stream;
determining a common point in time according to the detected transient event;
converting/transforming (315) the data stream to its first derivative representation;
using zero crossing information from the first derivative representation of the data stream to determine (320) a plurality of local minima and maxima and their relative offset in time to the common point in time, the zero crossing information being indicative of local minima or maxima occurring based on a direction of zero crossings indicated in the zero crossing information; and
providing (325) information from, or derived from, the plurality of local minima and maxima and the relative offset associated with the transient event, to an upstream device (130) in the power system (100) for further processing, the information provided to the upstream device (130) being a compressed or reduced amount of information in comparison to the data stream for the detected transient event.

2. The method (300) of claim 1, wherein the transient event is a voltage and/or current transient event.

3. The method (300) of claim 1, wherein the information derived from the local minima and maxima and the relative offset includes frequency, amplitude and oscillatory attack/decay information of a waveform of the detected transient event.

4. The method (300) of claim 1, wherein the upstream device (130) is responsive to the information from, or derived from, the local minima and maxima and the relative offset to characterize the transient event.

5. The method (300) of claim 4, wherein a magnitude of the transient event is characterized on the upstream device (130) by correlating the local minima and maxima and the relative offset associated with the transient event to the incoming data stream.

6. The method of claim 1, wherein the upstream device (130) is a computing system or device.

7. The method (300) of claim 1, wherein the high-speed data acquisition device (121) is provided in a metering device (120).

8. The method (300) of claim 1, wherein the high-speed data acquisition device (121) is coupled to a signal source (110), and the incoming data stream is received from the signal source (110).

9. The method (300) of claim 8, wherein the signal source (110) is a utility power source.

10. The method (300) of claim 1, further comprising:
characterizing the transient event using information from, or derived from, the local minima and maxima and the relative offset associated with the transient event.

11. The method (300) of claim 10, wherein the transient event is a voltage and/or current transient event.

12. The method (300) of claim 10, wherein the information derived from the local minima and maxima and the relative offset includes frequency, amplitude and oscillatory attack/decay information of a waveform of the detected transient event.

13. The method (300) of claim 10, wherein the transient event is characterized on a field programmable gate array (FPGA) of the high-speed transient device.

14. The method (300) of claim 10, wherein a magnitude of the transient event is **characterized by** correlating the local minima and maxima and the relative offset associated with the transient event to the incoming data stream.

15. The method (300) of claim 14, further comprising: providing resulting metadata to an upstream device (130) for further processing.

16. The method (300) of claim 15, wherein the metadata includes the magnitude and time offset of each local minima and maxima.

17. The method (300) of claim 10, wherein the high-speed data acquisition device (121) is provided in a metering device (120).

18. The method (300) of claim 10, wherein the high-speed data acquisition device (121) is coupled to a signal source (110), and the incoming data stream is received from the signal source (110).

19. The method (300) of claim 18, wherein the signal source (110) is a utility power source.

20. The method (300) of claim 10, further comprising:
storing the local minima and maxima and the relative offset on a memory device associated with the high-speed data acquisition device.

21. A high-speed data acquisition device (121), comprising:
a processor (123);
a memory device coupled to the processor (123), the processor (123) and the memory device configured to:
process an incoming high-speed data stream in the high-speed data acquisition device (121) to detect a transient event in a power system (100) from the data stream;
determine a common point in time according to the detected transient event;
convert/transform the data stream to its first derivative representation;
use zero crossing information from the first derivative representation of the data stream to determine a plurality of local minima and maxima and their relative offset in time to the common point in time, the zero crossing information being indicative of local minima or maxima occurring based on a direction of zero crossings indicated in the zero crossing information; and
provide information from, or derived from, the plurality of local minima and maxima and the relative offset associated with the transient event, to an upstream device (130) in the power system (100) for further processing, the information provided to the upstream device (130) being a compressed or reduced amount of information in comparison to the data stream for the detected transient event.

## Patentansprüche

1. Verfahren (300) zur Ableitung einer Information aus einem digitalen Datenstrom in einer Hochgeschwindigkeitsdatenerlangungseinrichtung (121), wobei das Verfahren umfasst, dass:
ein eingehender Hochgeschwindigkeitsdatenstrom in der Hochgeschwindigkeitsdatenerlangungseinrichtung (121) verarbeitet wird, um ein transientes Ereignis in einem Leistungssystem (100) aus dem Datenstrom zu detektieren (310);
ein gemeinsamer Zeitpunkt gemäß dem detektierten transienten Ereignis ermittelt wird;
der Datenstrom in eine Darstellung seiner ersten Ableitung umgewandelt/transformiert wird (315);
eine Nulldurchgangsinformation von der Darstellung der ersten Ableitung des Datenstroms verwendet wird, um eine Vielzahl von lokalen Minima und Maxima und ihren relativen zeitlichen Versatz zu dem gemeinsamen Zeitpunkt zu ermitteln (320), wobei die Nulldurchgangsinformation ein Auftreten lokaler Minima oder Maxima basierend auf einer Richtung von Nulldurchgängen, die in der Nulldurchgangsinformation angegeben ist, angibt; und
eine Information von, oder abgeleitet von, der Vielzahl von lokalen Minima und Maxima und dem relativen Versatz, der mit dem transienten Ereignis in Verbindung steht, einer stromaufwärtigen Einrichtung (130) in dem Leistungssystem (100) für eine weitere Verarbeitung bereitgestellt wird (325), wobei die der stromaufwärtigen Einrichtung (130) bereitgestellte Information eine komprimierte oder reduzierte Menge an Information im Vergleich zu dem Datenstrom für das detektierte transiente Ereignis ist.

2. Verfahren (300) nach Anspruch 1, wobei das transiente Ereignis ein transientes Spannungs- und/oder Stromereignis ist.

3. Verfahren (300) nach Anspruch 1, wobei die von den lokalen Minima und Maxima und dem relativen Versatz abgeleitete Information eine Information einer Frequenz, einer Amplitude und eines oszillatorischen Anstiegs/Abfalls einer Wellenform des detektierten transienten Ereignisses umfasst.

4. Verfahren (300) nach Anspruch 1, wobei die stromaufwärtige Einrichtung (130) auf die Information von, oder abgeleitet von, den lokalen Minima und Maxima und dem relativen Versatz anspricht, um das transiente Ereignis zu charakterisieren.

5. Verfahren (300) nach Anspruch 4, wobei ein Umfang des transienten Ereignisses an der stromaufwärtigen Einrichtung (130) charakterisiert wird, indem die lokalen Minima und Maxima und der relative Versatz, der mit dem transienten Ereignis in Verbindung steht, mit dem eingehenden Datenstrom in Korrelation gebracht werden.

6. Verfahren nach Anspruch 1, wobei die stromaufwärtige Einrichtung (130) ein Rechensystem oder eine Recheneinrichtung ist.

7. Verfahren (300) nach Anspruch 1, wobei die Hochgeschwindigkeitsdatenerlangungseinrichtung (121) in einer Messeinrichtung (120) vorgesehen ist.

8. Verfahren (300) nach Anspruch 1, wobei die Hochgeschwindigkeitsdatenerlangungseinrichtung (121) mit einer Signalquelle (110) gekoppelt ist, und der eingehende Datenstrom von der Signalquelle (110) empfangen wird.

9. Verfahren (300) nach Anspruch 8, wobei die Signalquelle (110) eine Leistungsversorgungsquelle ist.

10. Verfahren (300) nach Anspruch 1, ferner umfassend, dass:
das transiente Ereignis unter Verwendung einer Information von, oder abgeleitet von, den lokalen Minima und Maxima und dem relativen Versatz,
der mit dem transienten Ereignis in Verbindung steht, charakterisiert wird.

11. Verfahren (300) nach Anspruch 10, wobei das transiente Ereignis ein transientes Spannungs- und/oder Stromereignis ist.

12. Verfahren (300) nach Anspruch 10, wobei die von den lokalen Minima und Maxima und dem relativen Versatz abgeleitete Information eine Information einer Frequenz, einer Amplitude und eines oszillatorischen Anstiegs/Abfalls einer Wellenform des detektierten transienten Ereignisses umfasst.

13. Verfahren (300) nach Anspruch 10, wobei das transiente Ereignis an einem Universalschaltkreis (FPGA) der transienten Hochgeschwindigkeitseinrichtung charakterisiert wird.

14. Verfahren (300) nach Anspruch 10, wobei ein Umfang des transienten Ereignisses charakterisiert wird, indem die lokalen Minima und Maxima und der relative Versatz, der mit dem transienten Ereignis in Verbindung steht, mit dem eingehenden Datenstrom in Korrelation gebracht werden.

15. Verfahren (300) nach Anspruch 14, das ferner umfasst, dass:
resultierende Metadaten einer stromaufwärtigen Einrichtung (130) für eine weitere Verarbeitung bereitgestellt werden.

16. Verfahren (300) nach Anspruch 15, wobei die Metadaten den Betrag und den zeitlichen Versatz aller lokalen Minima und Maxima umfassen.

17. Verfahren (300) nach Anspruch 10, wobei die Hochgeschwindigkeitsdatenerlangungseinrichtung (121) in einer Messeinrichtung (120) vorgesehen ist.

18. Verfahren (300) nach Anspruch 10, wobei die Hochgeschwindigkeitsdatenerlangungseinrichtung (121) mit einer Signalquelle (110) gekoppelt ist, und der eingehende Datenstrom von der Signalquelle (110) empfangen wird.

19. Verfahren (300) nach Anspruch 18, wobei die Signalquelle (110) eine Leistungsversorgungsquelle ist.

20. Verfahren (300) nach Anspruch 10, das ferner umfasst, dass:
die lokalen Minima und Maxima und der relative Versatz an einer Speichereinrichtung, die der Hochgeschwindigkeitsdatenerlangungseinrichtung zugehörig ist, gespeichert werden.

21. Hochgeschwindigkeitsdatenerlangungseinrichtung (121), umfassend:
einen Prozessor (123);
eine Speichereinrichtung, die mit dem Prozessor (123) gekoppelt ist, wobei der Prozessor (123) und die Speichereinrichtung ausgestaltet sind, um:
einen eingehenden Hochgeschwindigkeitsdatenstrom in der Hochgeschwindigkeitsdatenerlangungseinrichtung (121) zu verarbeiten, um ein transientes Ereignis in einem Leistungssystem (100) aus dem Datenstrom zu detektieren;
einen gemeinsamen Zeitpunkt gemäß dem detektierten transienten Ereignis zu ermitteln;
den Datenstrom in eine Darstellung seiner ersten Ableitung umzuwandeln/ zu transformieren;
eine Nulldurchgangsinformation von der Darstellung der ersten Ableitung des Datenstroms zu verwenden, um eine Vielzahl von lokalen Minima und Maxima und ihren relativen zeitlichen Versatz zu dem gemeinsamen Zeitpunkt zu ermitteln, wobei die Nulldurchgangsinformation ein Auftreten lokaler Minima oder Maxima basierend auf einer Richtung von Nulldurchgängen, die in der Nulldurchgangsinformation angegeben ist, angibt; und
eine Information von, oder abgeleitet von, der Vielzahl von lokalen Minima und Maxima und dem relativen Versatz, der mit dem transienten Ereignis in Verbindung steht, einer stromaufwärtigen Einrichtung (130) in dem Leistungssystem (100) für eine weitere Verarbeitung bereitzustellen, wobei die der stromaufwärtigen Einrichtung (130) bereitgestellte Information eine komprimierte oder reduzierte Menge an Information im Vergleich zu dem Datenstrom für das detektierte transiente Ereignis ist.

## Revendications

1. Procédé (300) pour dériver des informations à partir d'un flux de données numériques dans un dispositif d'acquisition de données à grande vitesse (121), le procédé consistant à :
traiter un flux de données à grande vitesse entrant dans le dispositif d'acquisition de données à grande vitesse (121) pour détecter (310) un événement transitoire dans un système électrique (100) à partir du flux de données ;
déterminer un point commun dans le temps en fonction de l'événement transitoire détecté ;
convertir/transformer (315) le flux de données en sa première représentation dérivée ;
utiliser des informations de passage par zéro de la première représentation dérivée du flux de données pour déterminer (320) une pluralité de minima et maxima locaux et leur décalage relatif dans le temps par rapport au point commun dans le temps, les informations de passage par zéro étant indicatives de minima ou maxima locaux se produisant sur la base d'un sens de passage par zéro indiqué dans les informations de passage par zéro ; et
fournir (325) des informations provenant ou dérivées de la pluralité de minima et maxima locaux et du décalage relatif associés à l'événement transitoire à un dispositif en amont (130) dans le système électrique (100) pour un traitement ultérieur, les informations fournies au dispositif en amont (130) étant une quantité d'informations comprimée ou réduite par rapport au flux de données pour l'événement transitoire détecté.

2. Procédé (300) selon la revendication 1, dans lequel l'événement transitoire est un événement transitoire de tension et/ou de courant.

3. Procédé (300) selon la revendication 1, dans lequel les informations dérivées des minima et maxima locaux et du décalage relatif incluent des informations de fréquence, d'amplitude et d'attaque/décroissance oscillatoire d'une forme d'onde de l'événement transitoire détecté.

4. Procédé (300) selon la revendication 1, dans lequel le dispositif en amont (130) réagit aux informations provenant ou dérivées des minima et maxima locaux et du décalage relatif pour caractériser l'événement transitoire.

5. Procédé (300) selon la revendication 4, dans lequel une magnitude de l'événement transitoire est **caractérisée** sur le dispositif en amont (130) en corrélant les minima et maxima locaux et le décalage relatif associés à l'événement transitoire au flux de données entrant.

6. Procédé selon la revendication 1, dans lequel le dispositif en amont (130) est un système ou un dispositif informatique.

7. Procédé (300) selon la revendication 1, dans lequel le dispositif d'acquisition de données à grande vitesse (121) est prévu dans un dispositif de comptage (120).

8. Procédé (300) selon la revendication 1, dans lequel le dispositif d'acquisition de données à grande vitesse (121) est couplé à une source de signaux (110) et le flux de données entrant est reçu de la source de signaux (110).

9. Procédé (300) selon la revendication 8, dans lequel la source de signaux (110) est une source d'alimentation de fournisseur d'électricité.

10. Procédé (300) selon la revendication 1, consistant en outre à :
caractériser l'événement transitoire à l'aide d'informations provenant ou dérivées des minima et maxima locaux et du décalage relatif associés à l'événement transitoire.

11. Procédé (300) selon la revendication 10, dans lequel l'événement transitoire est un événement transitoire de tension et/ou de courant.

12. Procédé (300) selon la revendication 10, dans lequel les informations dérivées des minima et maxima locaux et du décalage relatif incluent des informations de fréquence, d'amplitude et d'attaque/décroissance oscillatoire d'une forme d'onde de l'événement transitoire détecté.

13. Procédé (300) selon la revendication 10, dans lequel l'événement transitoire est caractérisé sur un réseau de portes programmables sur site (FPGA) du dispositif transitoire à grande vitesse.

14. Procédé (300) selon la revendication 10, dans lequel une magnitude de l'événement transitoire est **caractérisée** en corrélant les minima et maxima locaux et le décalage relatif associés à l'événement transitoire au flux de données entrant.

15. Procédé (300) selon la revendication 14, consistant en outre à :
fournir des métadonnées résultantes à un dispositif en amont (130) pour un traitement ultérieur.

16. Procédé (300) selon la revendication 15, dans lequel les métadonnées incluent la magnitude et le décalage temporel de chaque minima et maxima local.

17. Procédé (300) selon la revendication 10, dans lequel le dispositif d'acquisition de données à grande vitesse (121) est prévu dans un dispositif de comptage (120).

18. Procédé (300) selon la revendication 10, dans lequel le dispositif d'acquisition de données à grande vitesse (121) est couplé à une source de signaux (110) et le flux de données entrant est reçu de la source de signaux (110).

19. Procédé (300) selon la revendication 18, dans lequel la source de signaux (110) est une source d'alimentation de fournisseur d'électricité.

20. Procédé (300) selon la revendication 10, consistant en outre à :
stocker les minima et maxima locaux et le décalage relatif sur un dispositif de mémoire associé au dispositif d'acquisition de données à grande vitesse.

21. Dispositif d'acquisition de données à grande vitesse (121), comprenant :
un processeur (123) ;
un dispositif de mémoire couplé au processeur (123), le processeur (123) et le dispositif de mémoire étant configurés pour :
traiter un flux de données à grande vitesse entrant dans le dispositif d'acquisition de données à grande vitesse (121) afin de détecter un événement transitoire dans un système électrique (100) à partir du flux de données ;
déterminer un point commun dans le temps en fonction de l'événement transitoire détecté ;
convertir/transformer le flux de données en sa première représentation dérivée ;
utiliser des informations de passage par zéro de la première représentation dérivée du flux de données pour déterminer une pluralité de minima et maxima locaux et leur décalage relatif dans le temps par rapport au point commun dans le temps, les informations de passage par zéro étant indicatives de minima ou maxima locaux se produisant sur la base d'un sens de passage par zéro indiqué dans les informations de passage par zéro ; et
fournir des informations provenant ou dérivées de la pluralité de minima et maxima locaux et du décalage relatif associés à l'événement transitoire à un dispositif en amont (130) dans le système électrique (100) pour un traitement ultérieur, les informations fournies au dispositif en amont (130) étant une quantité d'informations comprimée ou réduite par rapport au flux de données pour l'événement transitoire détecté.
